# EUROPEAN PATENT SPECIFICATION

(11) **EP 2 382 225 B1**
(45) Date of publication and mention of the grant of the patent: **28.08.2013**
(21) Application number: 09775043.4
(22) Date of filing: 08.12.2009
(51) Int. Cl.: C07F 15/00, C09K 11/06, H01L 51/50

(54) **ORGANIC METAL COMPLEXES FOR USE IN OPTOELECTRONIC DEVICES**
ORGANISCHE METALLKOMPLEXE ZUR VERWENDUNG IN OPTOELEKTRONISCHEN GERÄTEN
COMPLEXES DE MÉTAUX ORGANIQUES DESTINÉS À ÊTRE UTILISÉS DANS DES DISPOSITIFS OPTOÉLECTRONIQUES

(30) Priority: 23.12.2008 US 342604
(43) Date of publication of application: 02.11.2011
(73) Proprietor: General Electric Company, Schenectady, NY 12345 (US)
(72) Inventor: CHICHAK, Kelly, Scott, Clifton Park NY 12065 (US); BALES, Brian, Christopher, Niskayuna NY 12309 (US); LITZ, Kyle, Erik, Ballston Spa NY 12020 (US)
(74) Representative: Szary, Anne Catherine
(86) International application number: PCT/US2009/067115
(87) International publication number: WO 2010/074957

(56) References cited:
- WO-A1-2006/095951
- US-A1- 2004 127 710
- US-A1- 2008 305 361

## Description

### TECHNICAL FIELD

The invention relates to an organic metal complex, a composition comprising the organic metal complexes, use of the organic metal complexes, and an organic light-emitting device comprising the complexes.

### BACKGROUND OF THE INVENTION

An organic light emitting device (OLED) typically includes an anode, a cathode, and at least one organic light emitting layer sandwiched between two electrodes. The OLED may include additional layers such as a hole injection layer, a hole transport layer, an electron injection and an electron transport layer. Upon application of an appropriate voltage to the OLED, the injected positive and negative charges recombine in the organic light emitting layer to produce light.

Materials used in the organic light emitting layer are classified into a fluorescent material that uses singlet excitons and a phosphorescent material that uses triplet excitons, according to a light-emitting mechanism. The organic light emitting device using a fluorescent material as a light emitting layer-forming material has a disadvantage that the triplet excitons formed in the host are consumed, while the device using a phosphorescent material as a light emitting layer-forming material has an advantage that both of the singlet excitons and the triplet excitons can be used, and thus the internal quantum efficiency can reach up to 100%. Accordingly, when a phosphorescent material is used in the organic light emitting layer, the phosphorescent material can possess even higher light emitting efficiency than when a fluorescent material is used.

Organic metal complexes such as [(C∧N)₃Ir(III)] and [(C∧N)₂Ir(III)(L_{A})] iridium(III) complexes wherein C∧N is a cyclometallated ligand and L_{A} is an ancillary ligand have been identified as key phosphorescent materials in molecular- and polymer-based OLEDs due to their exceptional electro- and photo-luminescent properties. Much of the directed interest in employing these Ir(III) complexes in OLED architectures is a result of them having long lived excited states and high luminescent efficiencies.
US 2008/0305361 discloses phenylpyrazine derivatives ortho metalated with a metal ion of an element belonging to Group 9 or Group 10 in the periodic table, easily cause intersystem crossing, and can emit green phosphorescence.
WO 2006/095951 discloses a deuterated novel iridium complex phosphorescent material used as a light-emitting layer material of an organic electroluminescence device. Compared with an organic electroluminescence device using a prior art light-emitting layer with no deuterium substitution, the organic electroluminescence device using the deuterated material has improved luminescence efficiency, luminance, power efficiency and thermal stability.
US 2004/0127710 discloses a phosphorescent material containing an iridium metal compound. When used for an emissive layer of an organic electroluminescent device, the phosphorescent material offers greater luminescent efficiency and improved driving voltage characteristics, compared to conventional red luminescent materials, and reduces the amount of power consumed in the organic electroluminescent device.

Although complexes employing heavy metals such as an Ir, Pt, and Rh as a component used in highly efficient luminescent materials are reported, it is desirable that they are targeted for room temperature operation when fabricating the complexes or that the organic metal complexes or materials emit light at room temperature. Moreover, there is also a desire in developing an organic metal complex which emits light within the visible wavelength range, including, for example, red, blue or green light, at room temperature.

### BRIEF DESCRIPTION OF THE INVENTION

In one embodiment, the present invention provides an organic metal complex represented by the formula (I) 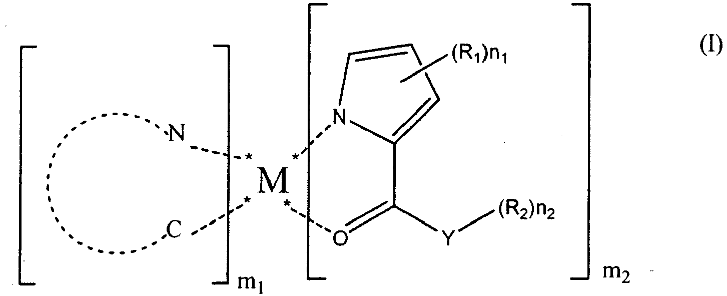 wherein
M is a metal selected from Rh, Ir, or Pt;
Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₃-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2;
m₁ has a value of at least 1; and
m₂ has a value of at least 1 provided that m₁+m₂ is 3;
wherein the ligand 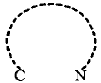 is independently at each occurrence a cyclometallated ligand which may be the same or different.

In another embodiment, the invention provides an organic light emitting device (OLED) comprising
an anode;
a cathode; and
an organic light emitting layer positioned between the anode and the cathode, wherein the organic light emission layer comprises an organic metal complex represented by the formula (I).

Yet another embodiment is an electrophosphorescent composition comprising at least one electroactive host material and at least one organic metal complex represented by the formula (I).

These and other features, aspects, and advantages of the present invention may be more understood more readily by reference to the following detailed description.

Hereinafter, the present invention will be described in more detail with reference to the embodiments below.

### DETAILED DESCRIPTION OF THE INVENTION

In this specification and in the claims, which follow, reference will be made to a number of terms which shall be defined to have the following meanings.

The singular forms "a," "an," and "the" include plural referents unless the context clearly dictates otherwise.

As used herein, the expression "optional" or "optionally" means that the subsequently described event or circumstance may or may not occur, and that the description includes instances where the event occurs and instances where it does not.

The endpoints of all ranges reciting the same characteristic are independently combinable and inclusive of the recited endpoint. Values expressed as "greater than" or "less than" are inclusive the stated endpoint, e.g., "greater than 3.5" encompasses the value of 3.5.

As used herein, the term "aromatic radical" refers to those comprising at least one aromatic group, wherein the at least one aromatic group may include heteroatoms such as nitrogen, sulfur, selenium, silicon and oxygen, or may be composed exclusively of carbon and hydrogen. The aromatic group comprises phenyl groups, thienyl groups, furanyl groups, naphthyl groups, azulenyl groups, anthraceneyl groups and the like. The aromatic radical may also include nonaromatic components. For example, a benzyl group is an aromatic radical which comprises a phenyl ring (the aromatic group) and a methylene group (the nonaromatic component). As used herein, the term "aromatic radical" includes but is not limited to phenyl, pyridyl, furanyl, thienyl, naphthyl, phenylene, and biphenyl radicals. For convenience, the term "aromatic radical" is defined herein to encompass 0 to ten, preferably one to six, more preferably one to four, most preferably one to two substituents such as alkyl groups, alkenyl groups, alkynyl groups, haloalkyl groups, haloaromatic groups, conjugated dienyl groups, alcohol groups, ether groups, aldehyde groups, ketone groups, carboxylic acid groups, acyl groups (for example carboxylic acid derivatives such as esters and amides), amine groups, nitro groups, and the like. The terms "alkyl", "alkenyl" and "alkenyl" contained in the substituents possess 1 to 50 carbon atoms, preferably 1 to 30 carbon atoms, more preferably 1 to 12 carbon atoms, still more preferably 1 to 6 carbon atoms. For example, the aromatic radicals include halogenated aromatic radicals such as 4-trifluoromethylphenyl, 4-chloromethylphen-1-yl, 4-(3-bromoprop-1-yl)phen-1-yl (i.e., 4-BrCH₂CH₂CH₂Ph-), and the like. Further examples of aromatic radicals include 4-allyloxyphen-1-oxy, 4-aminophen-1-yl (i.e., 4-H₂NPh-), 3-aminocarbonylphen-1-yl (i.e., NH₂COPh-), and the like. Preferably, the aromatic radical comprises 3 to 40 carbon atoms, preferably 3 to 20 carbon atoms, more preferably 3 to 16 carbon atoms, most preferably 3 to 14 carbon atoms.

As used herein the term "cycloaliphatic radical" in the term "C₃-C₅₀ cycloaliphatic radical" refers to a radical having a valence of at least one, and comprising an array of atoms which is cyclic but which is not aromatic. As defined herein a "cycloaliphatic radical" does not contain an aromatic group. A "cycloaliphatic radical" may comprise one or more noncyclic components. The cycloaliphatic radical may include heteroatoms such as nitrogen, sulfur and oxygen, or may be composed exclusively of carbon and hydrogen. For convenience, the term "cycloaliphatic radical" is defined herein to encompass a wide range of functional groups such as halogen including fluorine, chlorine, bromine, and iodine, alkyl groups, alkenyl groups, alkynyl groups, haloalkyl groups, conjugated dienyl groups, alcohol groups, ether groups, aldehyde groups, ketone groups, carboxylic acid groups, acyl groups (for example carboxylic acid derivatives such as esters and amides), amino groups, nitro groups, and the like. In one embodiment, the cycloaliphatic radical has 3 to 50 carbon atoms, preferably 3 to 30 carbon atoms, more preferably 3 to 20 carbon atoms, still more preferably 3 to 12 carbon atoms, and most preferably 3 to 6 carbon atoms.

As used herein the term "aliphatic radical" in the term "C₁-C₅₀ aliphatic radical" refers to an organic radical having a valence of at least one consisting of a linear or branched array of atoms which is not cyclic. Aliphatic radicals are defined to comprise at least one carbon atom. The array of atoms comprising the aliphatic radical may include heteroatoms such as nitrogen, sulfur, silicon, selenium and oxygen or may be composed exclusively of carbon and hydrogen. For convenience, the term "aliphatic radical" is defined herein to encompass, as part of the "linear or branched array of atoms which is not cyclic" a wide range of functional groups such as alkyl groups, alkenyl groups, alkynyl groups, haloalkyl groups, conjugated dienyl groups, alcohol groups, ether groups, aldehyde groups, ketone groups, carboxylic acid groups, acyl groups (for example carboxylic acid derivatives such as esters and amides), amine groups, nitro groups, and the like. By way of an example, a C₁-C₁₀ aliphatic radical contains at least one but no more than 10 carbon atoms. A methyl group (i.e., CH₃-) is an example of a C₁ aliphatic radical. A decyl group (i.e., CH₃(CH₂)₉-) is an example of a C₁₀ aliphatic radical. In one embodiment, the aliphatic radical has 1 to 50 carbon atoms, preferably 1 to 30 carbon atoms, more preferably 1 to 20 carbon atoms, still more preferably 1 to 12 carbon atoms, and most preferably 1 to 6 carbon atoms.

As used herein, the term "5- or 6-membered ring" refers to a saturated, unsaturated, aromatic, non-aromatic 5- or 6-membered ring containing from 1 to 4 hetero atoms selected from N, S or O and may be substituted with a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical wherein the aromatic radical, aliphatic radical, and cycloaliphatic radical are defined as above.

In the course of extensive research, the present inventors discovered that a new class of organic metal complexes which showed better phosphorescence at a wavelength of from 400 nm to 650nm at room temperature.

### ORGANIC METAL COMPLEX

In one embodiment, the invention provides an organic metal complex represented by the formula (I). 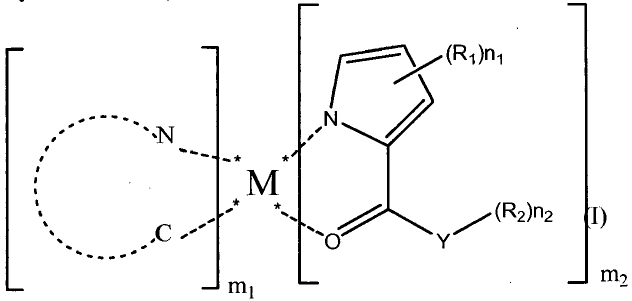 wherein
M is a metal selected from Rh, Ir, or Pt;
Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₃-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2;
m₁ has a value of at least 1; and
m₂ has a value of at least 1 provided that m₁+m₂ is 3;
wherein the ligand 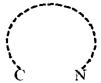 is independently at each occurrence a cyclometallated ligand which may be the same or different.

In the formula (I), the number m₁ of the cyclometalated ligand represented by 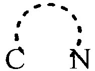 may be one or two, and when the number m₁ of the ligand is two, the cyclometalated ligands may be each other the same or different.

Suitable cyclometalated ligands used for the complexes are known in the art. Numerous cyclometalated ligands are disclosed in the art, e.g., WO 2006/073112, which is incorporated herein by reference in their entirety. A person skilled in the art can determine the cyclometalated ligands to be used.

In one embodiment, in the cyclometalated ligand 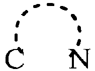 C and N are independently selected from a ring-forming atom of an aromatic radical. The aromatic radical is defined as above. The cyclometalated ligand, together with the metal M in the formula (I), forms a 5- to 7-membered ring, preferably a 5- to 6-membered ring.

In one embodiment, C in the cyclometalated ligand is a ring-forming atom in a C₃-C₁₄ aromatic radical and N in the cyclometalated ligand is a ring-forming atom in a nitrogen-containing 3- to 14-membered aromatic radical. The term "a nitrogent-containing 3- to 14-membered aromatic radical" refers to mono- or fused-aromatic radicals containing at least one N atom in the aromatic group in addition to carbon atoms. For example, the 3- to 14-membered aromatic radical comprises, but not limits to, 1-imidazolyl (C₃H₂N₂-), phenyl, benzyl radical (C₇H₇-), styryl, naphthyl, pyridinyl, indole and anthracenyl.

For example, the cyclometalated ligand may be any one selected from the group consisting of:

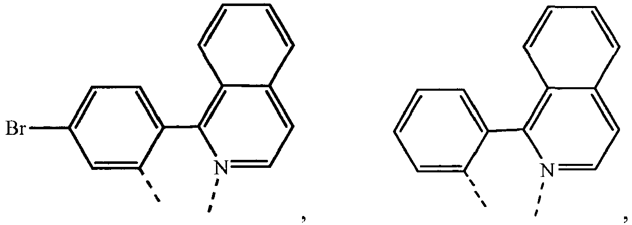

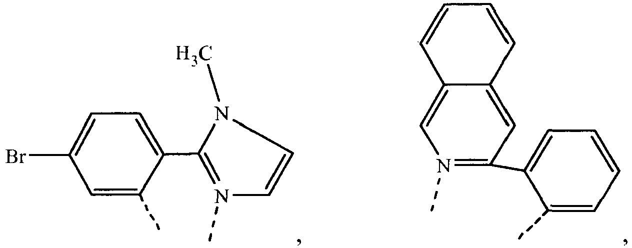

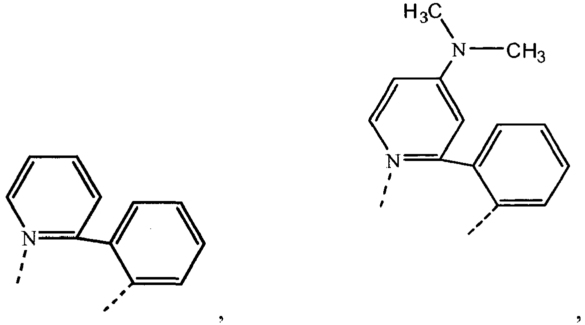

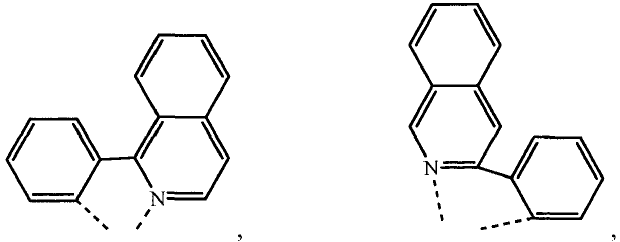

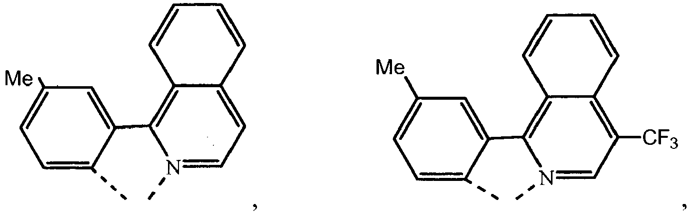

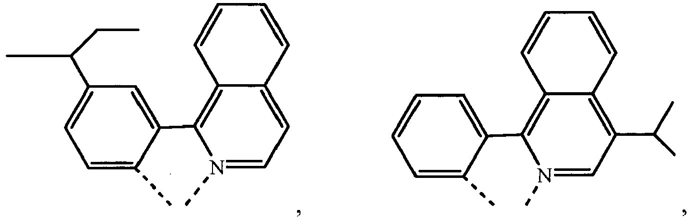

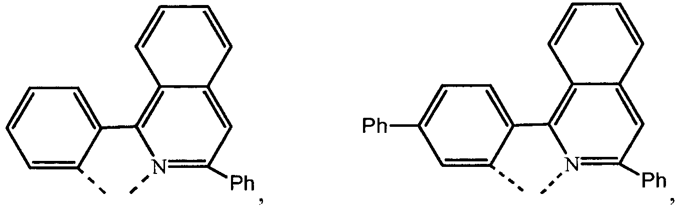

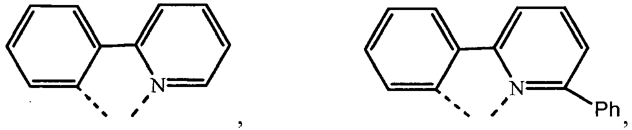

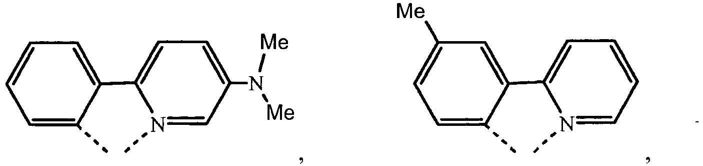

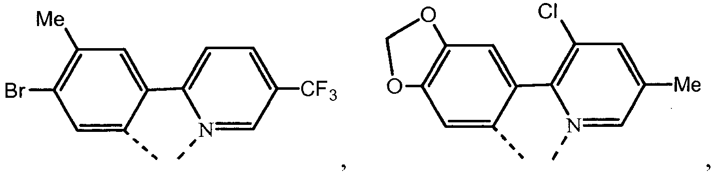

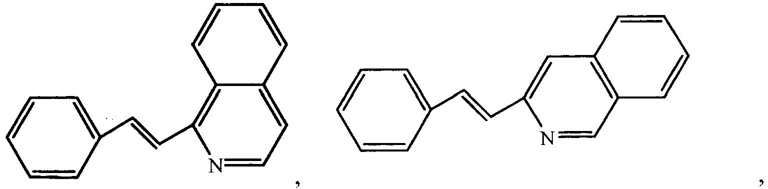

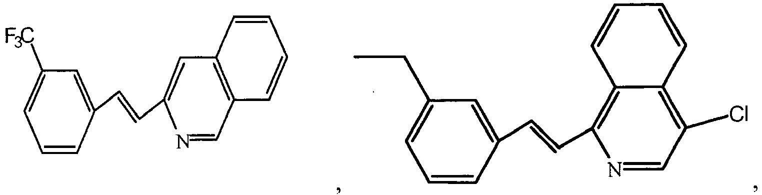

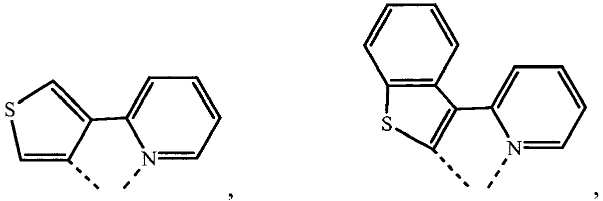

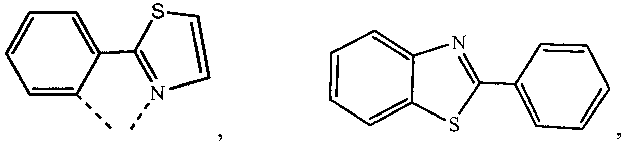

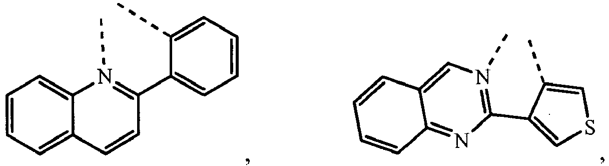

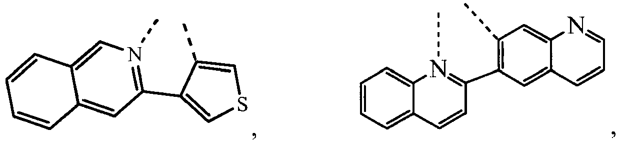

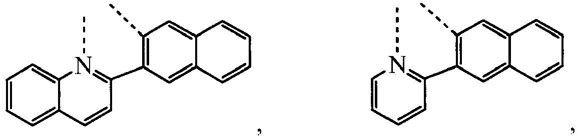

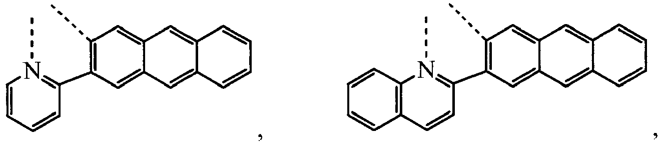

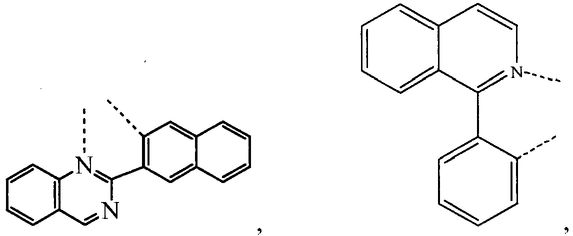

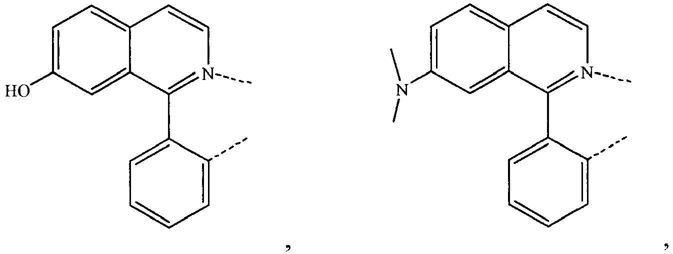

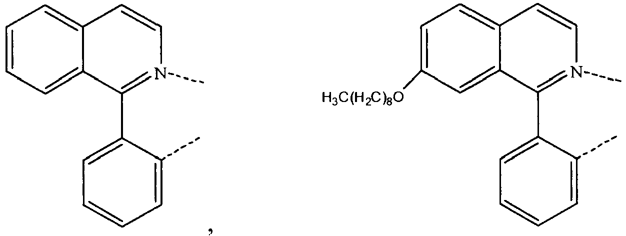

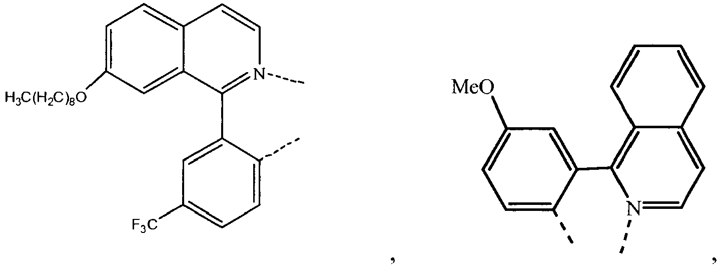

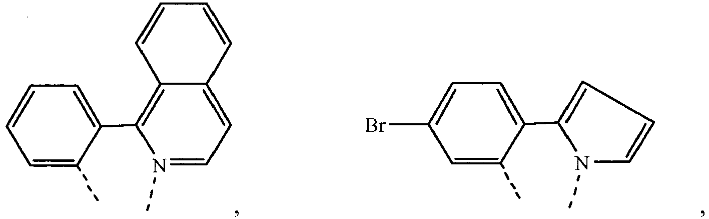

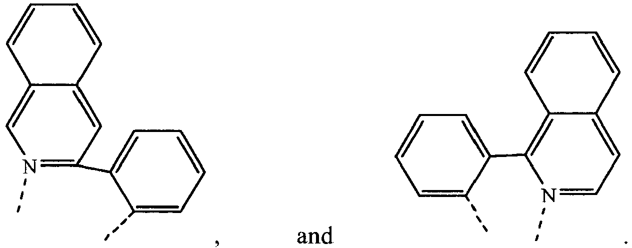

In the formula (I), M is a metal atom selected from Rh, Ir, and Pt. Preferably, M is Ir or Pt, more preferably Ir.

In the formula (I), the ligand represented by following formula (II) is included, 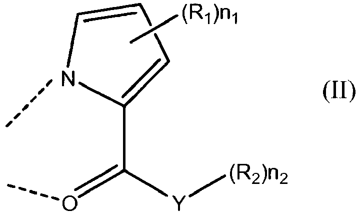 wherein Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₁-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2.

In the formula (I), the number m₂ of the ligand having formula (II) has a value of at least 1, such as I or 2, provided that m₁+m₂ =3. When m₂ is 2, the ligands having formula (II) can be the same or different.

Exemplified ligand having formula (II) comprises, but is not limited to those derived from following compounds:

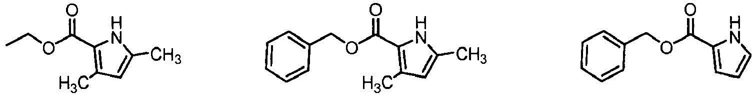

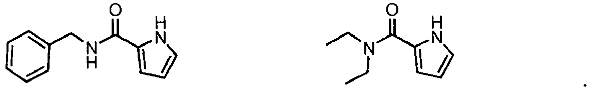

In one embodiment, Y represents N. In that case, exemplified ligand having formula (II) comprises, but is not limited to:

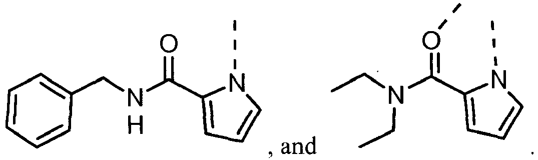

In the case where Y represents N, the complex according to the invention has a formula (III), 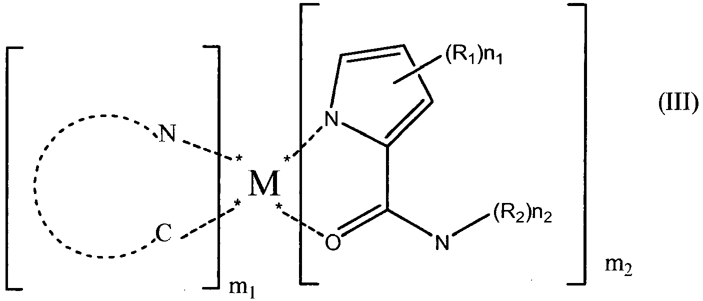 wherein M, R₁, R₂, n₁, n₂, m₁, and m₂ each is defined as above in formula (I) and (II). The ligand 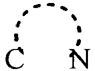 is also defined as above in formula (I).

### COMPOSITION

In one embodiment, the invention provides a composition comprising at least one organic metal complex represented by the formula (I): 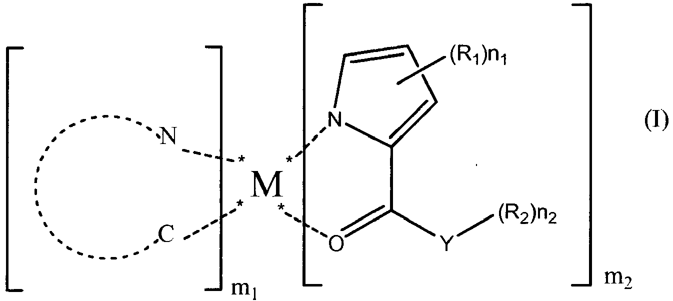 wherein M, R₁, R₂, n₁, n₂, mit, and m₂ each is defined as above.

In another embodiment, the invention provide an electrophosphorescent composition comprising at least one electroactive host material and at least one organic metal complex represented by the formula (I): 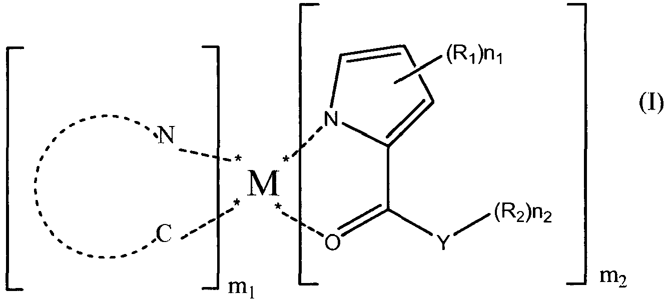 wherein M, R₁, R₂, n₁, n₂, m₁, and m₂ each is defined as above.

As used herein, an electrophosphorescent composition is a composition which emits light by radiative decay of a triplet excited state formed as a result of the application of a voltage bias.

In one embodiment, the present invention provides an electrophosphorescent composition which when subjected to a voltage bias, emits light primarily from a triplet excited state of an organic metal complex formed by energy transfer from the host material to the organic metal complex. The organic metal complexes provided by the present invention are well suited for use in electrophosphorescent compositions because energy transfer from the excited state of the host material to the organic metal complex is in many instances exceedingly efficient.

The composition further comprises electroactive host materials. Suitable electroactive host materials include electroluminescent materials and otherwise electroactive materials and they are known in the art. Examples of non-polymeric host materials include, but are not limited to, those exemplified in Table 1 together with their Chemical Abstracts Registry Number (CAS No.).

**Table 1: Exemplary Non-Polymeric Host Materials**

| | |
|---|---|
| 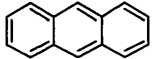 | 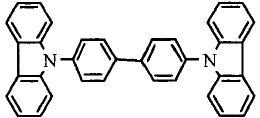 |
| anthrance | CBP |
| CAS No. 120-12-7 | CAS No. 58328-31-7 |
| 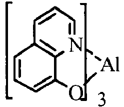 | 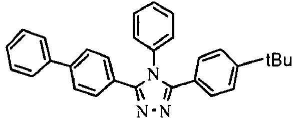 |
| Alq₃ | TAZ |
| CAS No. 2085-33-8 | CAS No. 150405-69-9 |
| 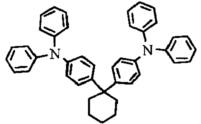 | 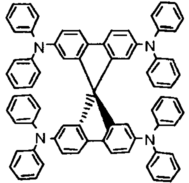 |
| BTA | Spiro-TAD |
| CAS No. 145024-29-9 | CAS No. 189363-47-1 |
| 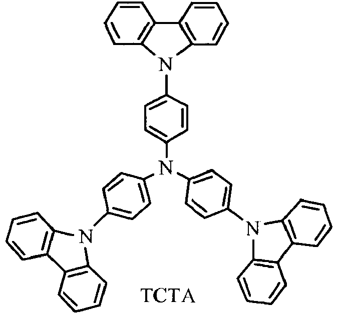 | 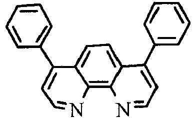 |
| | Bphen |
| CAS No. 139092-78-7 | CAS No. 1662-01-7 |

In an alternate embodiment, the host material is an electroactive polymeric material. Suitable electroactive polymeric materials include polyvinylcarbazole (PVK), polyphenylenevinylene (PPV), phenyl-substituted polyphenylenevinylene (PhPPV), and poly(9,9-disubstituted fluorenes).

In one embodiment, the present invention provides an electrophosphorescent composition comprising at least one electroactive host material and at least one organic metal complex.

In one embodiment, the electrophosphorescent composition comprises a host material which is a blue light emitting electroluminescent organic material, for example, poly(9,9-dioctyl fluorene).

In one embodiment, the present invention provides an electrophosphorescent composition comprising an electroactive host material and an organic metal complex of formula (I), wherein the organic metal complex is present in an amount corresponding to from about 0.01 percent to about 50 percent by weight of the entire weight of the electrophosphorescent composition. In another embodiment, the organic metal complex is present in an amount corresponding to from about 0.1 percent to about 10 percent by weight of the entire weight of the electrophosphorescent composition. In yet another embodiment, the organic metal complex is present in an amount corresponding to from about 0.5 percent to about 5 percent by weight of the entire weight of the electrophosphorescent composition.

### USE OF THE ORGANIC METAL COMPLEX

In one embodiment, the present invention provides use of an organic metal complex represented by the following formula (I) in electronic devices, light emitting electrochemical cells, photo detectors, photoconductive cells, photo switches, phototransistors, and phototubes: 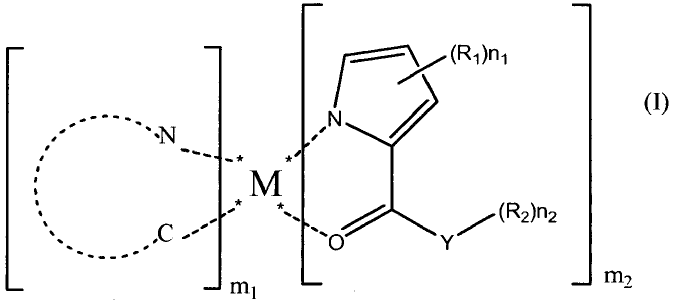 wherein M, R₁, R₂, n₁, n₂, m₁, and m₂ each is defined as above.

### OLED

In one embodiment, the invention provides an organic light emitting device comprising at least one of the organic metal complexes or compositions provided by the present invention. An organic light emitting device typically comprises multiple layers which include in the simplest case, an anode layer and a corresponding cathode layer with an organic electroluminescent layer disposed between said anode and said cathode. When a voltage bias is applied across the electrodes, electrons are injected by the cathode into the electroluminescent layer while electrons are removed from (or "holes" are "injected" into) the electroluminescent layer from the anode. Light emission occurs as holes combine with electrons within the electroluminescent layer to form singlet or triplet excitons, light emission occurring as singlet excitons transfer energy to the environment by radiative decay. Triplet excitons, unlike singlet excitons, typically cannot undergo radiative decay and hence do not emit light except at very low temperatures. Theoretical considerations dictate that triplet excitons are formed about three times as often as singlet excitons. Thus the formation of triplet excitons, represents a fundamental limitation on efficiency in organic light emitting devices which are typically operated at or near ambient temperature. In one aspect, the organic metal compositions provided by the present invention may serve as precursors to light emissive, short-lived excited state species which form as the normally unproductive triplet excitons encounter and transfer energy to the organic iridium composition. Thus, in one aspect, the present invention provides more efficient organic light emitting devices comprising at least one of the organic iridium compositions of the present invention.

In one embodiment, the invention provides an electronic device comprising one or more of the complexes or compositions of the invention. In particular, the invention provides an organic light emitting device (OLED) comprising
an anode,
a cathode, and
an organic light emitting layer positioned between the anode and the cathode, wherein the organic light emission layer comprises an organic metal complex represented by the formula (I) 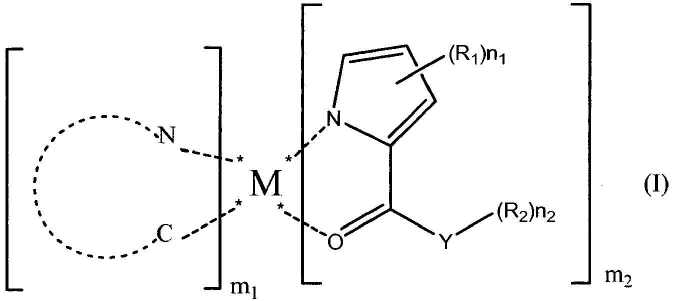 wherein M, R₁, R₂, n₁, n₂, m₁, and m₂ each is defined as above.

In one embodiment, the present invention provides an electronic device comprising at least one electroactive layer comprising an organic metal composition of the present invention.

In one embodiment, the present invention provides an organic light emitting device, comprising an anode; a cathode; and an organic electroluminescent layer disposed between and electrically connected to the anode and the cathode, wherein the organic electroluminescent layer comprising an electrophosphorescent composition.

In this disclosure, the organic electroluminescent layer is at times referred to as a "bipolar emission layer" and, as the previous discussion suggests, is a layer within an organic light emitting device which when in operation contains a significant concentration of both electrons and holes and provides sites for exciton formation and light emission.

Other components which may be present in an organic light emitting device include: a "hole injection layer" which is defined as a layer in contact with the anode which promotes the injection of holes from the anode into the interior layers of the OLED; and an "electron injection layer" which is defined as a layer in contact with the cathode that promotes the injection of electrons from the cathode into the interior layers of the OLED; an "electron transport layer" which is defined as a layer which facilitates conduction of electrons from cathode to a charge recombination site. The electron transport layer need not be in contact with the cathode, and frequently the electron transport layer is not an efficient hole transporter and thus it serves to block holes migrating toward the cathode.

In one embodiment, the organic light emitting device comprises
an anode;
a hole injection layer;
an organic electroluminescent layer disposed between and electrically connected to the anode and the cathode, wherein the organic electroluminescent layer comprising an electrophosphorescent composition;
an electron transport layer;
an electron injection layer; and
a cathode.

Materials suitable for use as anode are illustrated by materials having a bulk conductivity of at least about 100 Ω/□ (ohms per square), as measured by a four-point probe technique. Indium tin oxide (ITO) is typically used as the anode because it is substantially transparent to light transmission and thus facilitates the escape of light emitted from electro-active organic layer. Other materials which may be utilized as the anode layer include tin oxide, indium oxide, zinc oxide, indium zinc oxide, zinc indium tin oxide, antimony oxide, and mixtures thereof.

Materials suitable for use as cathode are illustrated by zero valent metals which can inject negative charge carriers (electrons) into the inner layer(s) of the OLED. Various zero valent metals suitable for use as the cathode include K, Li, Na, Cs, Mg, Ca, Sr, Ba, Al, Ag, Au, In, Sn, Zn, Zr, Sc, Y, elements of the lanthanide series, alloys thereof, and mixtures thereof. Suitable alloy materials for use as the cathode layer include Ag-Mg, Al-Li, In-Mg, Al-Ca, and Al-Au alloys. Layered non-alloy structures may also be employed as the cathode, for example a thin layer of a metal such as calcium, or a metal fluoride, such as LiF, covered by a thicker layer of a zero valent metal, such as aluminum or silver. In one embodiment, the cathode consists essentially of a single zero valent metal, for example a cathode consisting essentially of aluminum metal. The cathode may be deposited on the underlying element by physical vapor deposition, chemical vapor deposition, sputtering, or like technique. In one embodiment the cathode is transparent. The term "transparent" means allowing at least 50 percent, commonly at least 80 percent, and more commonly at least 90 percent, of light in the visible wavelength range to be transmitted through at an incident angle of less than or equal to 10 degrees. This means that a device or article, for example a cathode, described as being "transparent" will transmit at least 50 percent of light in the visible range which impinges on the device or article at an incident angle of about 10 degrees or less.

### EFFECT OF THE ORGANIC METAL COMPLEX

The organic metal complexes or compositions of the present invention typically display strong charge transfer bands in their UV-Vis absorption spectra. Without being bound to the theory, such absorption bands are believed to result from the transfer of electrons from molecular orbitals that are primarily ligand in character to molecular orbitals that are primarily metal in character, or alternatively, transfer of electrons from molecular orbitals that are primarily metal in character to molecular orbitals that are primarily ligand in character. Such charge transfer events are designated variously as Ligand-to-Metal Charge Transfer (LMCT) or Metal-to-Ligand Charge Transfer (MLCT). In certain embodiments the organic metal compositions provided by the present invention are characterized by highly emissive excited states that may be produced when a voltage is applied. Materials possessing such properties are useful in the preparation of electronic devices, for example organic light emitting diodes (OLEDs). Other applications in which the organic metal complexes of the present invention may be used include light emitting electrochemical cells, photo detectors, photoconductive cells, photo switches, phototransistors, and phototubes.

The organic metal complexes and the device comprising the complexes can emit light at room temperature.

The present invention will be described in greater detail with reference to the following examples. The following examples are for illustrative purpose and are not intended to limit the scope of the invention.

### EXAMPLES

### Definition of Tests

Thin layer chromatography (TLC) was performed on glass plates coated with silica-gel 60F (Merck 5715-7). The plates were inspected using UV light.

Column chromatography was carried out using silica-gel 60 (Merck 9358, 230-400 mesh).

All ¹H- and ¹³C NMR spectra were recorded on a Bruker Advance 500 NMR spectrometer (at 500 MHz and 125 MHz, respectively) or a Bruker 400 NMR spectrometer (at 400 and 100 MHz, respectively). Chemical shifts were determined relative to tetramethylsilane using the residual solvent peak as a reference standard.

### GENERAL PROCEDURE

To a nitrogen purged solution containing a mixture of 2-methoxyethanol and water was added IrCl₃•xH₂O (Strem Chemicals) followed by the addition of the cyclometallating ligand precursor (2.5-3.8 equiv.). The resulting mixture was heated at reflux for 15-48 h and the product was collected by vacuum filtration. In the following examples, the abbreviations "ppy", "piq", "F₂ppy" and "C6" have the following structures shown in Table 2. The asterisks (*) signal the point of attachment of the cyclometallated ligand to metal.

**Table 2**

| Ligand Abbreviation | Ligand Chemical Structure | Chemical Name of Ligand Precursor |
|---|---|---|
| "ppy" | 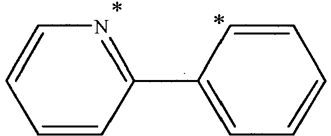 | 2-phenylpyridine |
| "piq" | 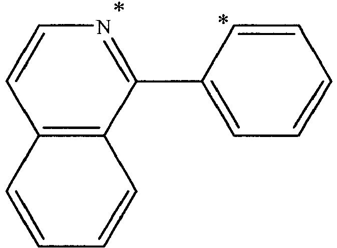 | 1-phenyl-isoquinoline |
| | | |
| "F₂ppy" | 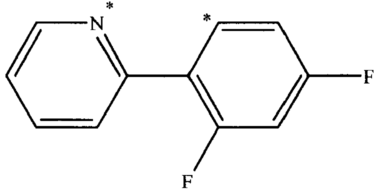 | 2-(2,4-difluoro-phenyl)pyridine |
| | | |
| "C6" | 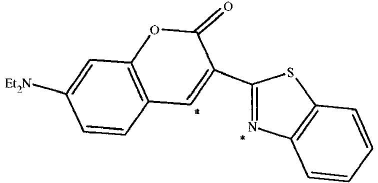 | Coumarin 6 |

### EXAMPLE 1

{(ppy)₂Ir(µ-Cl)}₂: A mixture of 2-methoxyethanol and water (30 ml : 10 mL) was degassed with N₂ for 15 min. To this solvent mixture was added IrCl₃•xH₂O (0.388 g, 1.30 mmol) followed by 2-phenylpyridine (0.766 g, 4.94 mmol) and the mixture was heated at reflux for 24 h under an atmosphere of N₂. The reaction mixture was cooled to room temperature and the yellow precipitate was collected by filtration and washed with EtOH (50 mL), acetone (50 mL), and dried in air. The yellow precipitate was dissolved in CH₂Cl₂ and filtered to remove an insoluble material. The solution was concentrated to dryness and filtered after being suspended in hexanes. Yield: 0.539 g, 77%. ¹H-NMR (400 MHz, CD₂Cl₂, 25 °C) *δ*5.88 (d, 2H), 6.60 (m, 2H), 6.82 (m, 4H), 7.56 (d, 2H), 7.80 (m, 2H), 7.94 (d, 2H), 9.25 (d, 2H).

### EXAMPLE 2

{(F₂ppy)₂Ir(µ-Cl)}₂: A mixture of 2-methoxyethanol and water (20 ml : 10 mL) was degassed with N₂ for 15 min. To this solvent mixture was added IrCl₃•xH₂O (0.388 g, 1.30 mmol) followed by 2-(2,4-difluoropheny)-pyridine (0.766 g, 4.94 mmol) and the mixture was heated at reflux for 15 h under an atmosphere of N₂. The reaction mixture was cooled to room temperature and poured into MeOH (200 mL). The yellow precipitate was collected by filtration and washed with MeOH and hexanes until the filtrate washes were colorless. The yellow precipitate was recrystallized from a mixture of toluene and hexanes to afford yellow needles. Yield: 2.20 g, 44%. ¹H-NMR (400 MHz, CD₂Cl₂, 25 °C) *δ*5.29 (m, 4H), 6.38 (m, 4H), 6.87 (m, 4H), 7.87 (m, 4H), 8.33 (m, 4H), 9.12 (m, 4H).

The ester derivatives of 2-pyrrolecarboxylic acid, [(F₂ppy)₂Ir(7)] (9) and [(F₂ppy)₂Ir(8)] (10), were prepared from the corresponding pyrrole ligand 7 and pyrrole ligand 8, respectively (Scheme 1).

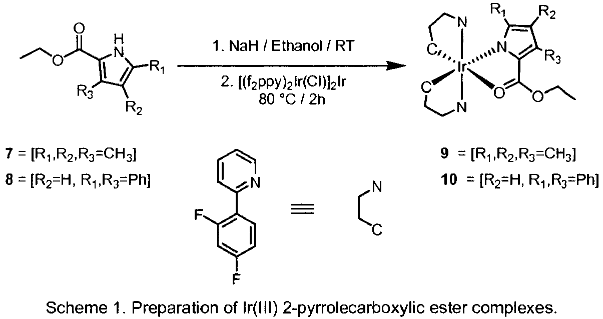

### EXAMPLE 3

[(F₂ppy)₂Ir(7)] (9): To a stirred EtOH solution (3 mL) containing the pyrrole ligand 7 (57 mg, 0.32 mmol) (The pyrrole ligand 7, ethyl-3,4,5-trimethyl-pyrrole-2-carboxylate, was prepared following a known literature procedure. See D. H. Cho, J. Ho Lee, B. H. Kim, J. Org. Chem., 1999, 21, 8048-8050.) was added solid sodium hydride (40.0 mg, 1.67 mmol) at -10 °C. After letting this solution stir for 5 min, [(f₂ppy)₂Ir(µ-Cl)]₂ (160 mg, 0.128 mmol) was added and the mixture was then heated at 80 °C for 2 hr. The yellow colored reaction mixture was cooled to room temperature and concentrated on a rotary evaporator without a heating bath. The now chilled solution was filtered to remove the product and the product was collected by filtration, washed with MeOH, and dried in air. Yield (170 mg, 88%). ¹H NMR (500 MHz, CD₂Cl₂, 25 °C) *δ*1.25 (t, 3H), 1.38 (s, 3H), 1.82 (s, 3H), 2.23 (s, 3H), 4.19 (m, 1H), 4.30(m, 1H), 5.66 (dd, 1H), 5.72 (dd, 1H), 6.40 (m, 2H), 7.08 (t, 1H), 7.20 (t, 1H), 7.63 (d, 1H), 7.79 (m, 2H), 8.23 (d, 2H), 8.45 (d, 1H).

### EXAMPLE 4

Ethyl-3,5-diphenyl-pyrrole-2-carboxylate (pyrrole ligand 8) was prepared using a modified version of the procedure described in the literature (J. B. Paine, D. Dolphin, J. Org. Chem., 1985, 50, 5598-5604). To a flask charged with 1,3-diphenylpropanedione (2.2 g, 1.0 mmol) and diethyl aminomalonate hydrochloride (2.1 g, 1.0 mmol) was added AcOH (2 mL). The mixture was heated at 90 °C for 1 h, after which an additional 2.1 g (1 mmol) of diethyl aminomalonate hydrochloride was added and heating was continued for 11 h. The reaction mixture was poured into in ice water (20 mL) with stirring followed by 10 mL of EtOH and stirred for 1 h. The precipitate was collected by filtration and washed with H₂O and dried in air (2.7 g). The crude product was chromatographed through SiO₂ and eluted with CH₂Cl₂/Hexanes (1:1). Removal of solvents from combined fractions containing the product afforded an off-white solid. The product was recrystallized from CH₂Cl₂/Hexanes to give colorless crystals. Yield: 1.8 g, 62%. ¹H NMR (400 MHz, CD₂Cl₂, 25 °C) *δ*1.27 (t, 3H), 4.25 (q, 2H), 6.66 (d, 1H), 7.39 (m, 6H), 7.62 (m, 4H), 9.45 (bs, 1H). The ¹H NMR spectrum of the product was consistent with literature data. See: A. Fürstner, H. Weintritt, A. Hupperts, J. Org. Chem., 1995, 60, 6637-6641.

[(F₂ppy)₂Ir(8)] (10): To a stirred EtOH solution (3 mL) containing the pyrrole ligand 8 (93 mg, 0.32 mmol) was added solid sodium hydride (40.0 mg, 1.67 mmol) at-10 °C. After letting this solution stir for 5 min, [(f₂ppy)₂Ir(µ-Cl)]₂ (160 mg, 0.128 mmol) was added and the mixture was then heated at 80 °C for 2 hr. The yellow colored reaction mixture was cooled to room temperature and concentrated on a rotary evaporator without a heating bath. The now chilled solution was filtered to remove the product and the product was collected by filtration, washed with MeOH, and dried in air. Yield (204 mg, 92%). ¹H NMR (400 MHz, CD₂Cl₂, 25 °C) *δ*1.14 (t, 3H), 4.16 (m, 1H), 4.29 (m, 1H), 5.19 (dd, 1H), 5.56 (dd, 1H), 6.09 (m, 1H), 6.31 (s, 1H), 6.38 (m, 1H), 6.74 (m, 2H), 6.85 (m, 2H), 6.93 (m, 1H), 7.15 (m, 1H), 7.25 (m, 2H), 7.33 (m, 2H), 7.57 (m, 2H), 7.64 (m, 1H), 7.79 (m, 1H), 7.86 (m 1H), 8.24 (m, 2H), 8.55 (m, 1H).

As solids, complex [(F₂ppy)₂Ir(7)] (9) emitted blue-green light and the complex [(F₂ppy)₂Ir(8)] (10) unexpectedly emitted yellow light. At room temperature degassed solutions complex 9 was weakly blue-green emissive at room-temperature, whereas, complex 10 weakly yellow emissive. In frozen glassy-toluene, complex 9 was a strongly blue emissive while complex 10 was strongly green emissive.

### EXAMPLE 5

N-(phenylmethyl)-1H-Pyrrole-2-carboxamide (the pyrrole ligand 11): To a stirred toluene solution (50 mL) containing a suspension of 2-pyrrole carboxylic acid (1.0 g, 9.0 mmol) maintained at -10 °C was added oxalyl chloride (1.65 mL, 18.92 mmol). The cooling bath was removed and stirred at room temperature for 12 h. The volatile solvents were removed and the remaining toluene solution (30 mL) containing the acid chloride was used without futher purification. To a 15 mL portion of the toluene solution containing the acid chloride (4.5 m mol) was added a toluene solution (5 mL) containing Et₃N (3 mL) and benzylamine (1.0 mL) and stirred at RT for 1.5 h. After which, the reaction mixture was washed with H₂O (100 mL), 5% HCl (3x 100 mL), satd. NaHCO₃ (1×100 mL), brine (1×100 mL), and dried over MgSO₄. Concentration of the dried toluene solution afforded the product as an off-white solid. Recrystallized from CH₂Cl₂/Hexanes. Yield: 0.47 g, 52%. ¹H NMR (500 MHz, CD₂Cl₂, 25 °C) *δ*4.60 (d, 2H), 6.21 (m, 1H), 6.40 (bs, 1H), 6.60 (m, 1H), 6.90 (m, 1H), 7.27 (m, 1H), 7.34 (d, 4H), 10.14 (bs, 1H).

[(F₂ppy)₂Ir(11)] (13): To a stirred THF (anhydrous) solution (4 mL) was added solid sodium hydride (15.0 mg, 0.625 mmol) at -10 °C. After letting this solution stir for 10 min, the pyrrole ligand 11 (102 mg, 0.512 mmol) and stirring was continued for 10 min. To this solution was added [(f₂ppy)₂Ir(µ-Cl)]₂ (160 mg, 0.128 mmol) and the mixture was stirred at RT for 2h by which time the solution became homogeneous. The mixture was poured into a mixture of MeOH/H₂O/NH₄Cl(aq) (150 ml/25 mL/0.3 mL) and concentrated to dryness. The crude product was chromatographed through SiO₂ (CH₂Cl₂). After removal of solvents to near dryness to give a glassy film, the product was crystallized upon the addition of MeOH (15 mL). The product was collected by a filtration and washed with 70% MeOH and dried in air. Yield (180 mg, 91 %). ¹H NMR (500 MHz, CD₂Cl₂, 25 °C) *δ*4.5I (dd, 1H), 4.61 (dd, 1H), 5.77 (m, 2H), 6.13 (m, 1H), 6.35 (m. 2H), 6.42 (m, 2H), 6.69 (d, 1H), 7.03 (m, 1H), 7.11 (m, 3H), 7.25 (m 3H), 7.34 (d, 1H), 7.75 (t, 1H), 7.80 (t, 1H), 8.22 (d, 1H), 8.26 (d, 1H), 8.41 (d, 1H).

### EXAMPLE 6

N-[(4-methoxyphenyl)methyl]-1H-Pyrrole-2-carboxamide (pyrrole ligand 12): To a stirred CH₂Cl₂ solution (20 mL) containing a suspension of 2-pyrrole carboxylic acid (1.0g, 9.0 mmol) maintained at -10 °C was added oxalyl chloride (3.0 mL). The cooling bath was removed and stirred at room temperature for 4 h. The volatile solvents were removed and the residue was redissolved in CH₂Cl₂ (20 mL). The CH₂Cl₂ solution containing the acid chloride was treated with a mixture of Et₃N (3 mL) and 4-methoxybenzylamine (1.0mL) and stirred at room temperatue for 3 h. After which, the reaction mixture was washed with H₂O (100 mL), 5% HCl (3×100 mL), satd. NaHCO₃ (1×100 mL), brine (1×100 mL), and dried over MgSO₄. Crude solid was dissolved in EtOAc and upon cooling a crystalline material was formed and removed by filtration. The mother liquor was concentrated to dryness and recrystallized from EtOAc/Hexanes. Yield: 0.57 g, 28%. ¹H NMR (500 MHz, CD₂Cl₂, 25 °C) *δ*3.78 (s, 3H), 4.52 (d, 2H), 6.21 (m, 1H), 6.31 (bs, 1H), 6.57 (m, 1H), 6.87 (d, 2H), 6.91 (m, 1H), 7.27 (d, 2H), 10.02 (bs, 1H).

[(F₂ppy)₂Ir(12)] (14): To a stirred THF (anhydrous) solution (4 mL) was added solid sodium hydride (15.0 mg, 0.625 mmol) at -10 °C. After letting this solution stir for 10 min, the pyrrole ligand 12 (117 mg, 0.512 mmol) was added and stirring was continued for 10 min. To this solution was added [(f₂ppy)₂Ir(µ-Cl)]₂ (160 mg, 0.128 mmol) and the mixture was stirred at RT for 2h by which time the solution became homogeneous. The mixture was poured into a mixture of MeOH/H₂O/NH₄Cl_{(aq)} (150 ml/25 mL/0.3 mL) and concentrated to dryness. The crude product was chromatographed through SiO₂ (CH₂Cl₂). After removal of solvents to near dryness to give a glassy film, the product was crystallized upon the addition of MeOH (15 mL). The product was collected by filtration and washed with 70% MeOH and dried in air. Yield (194 mg, 95%). ¹H NMR (400 MHz, CD₂Cl₂, 25 °C) *δ*3.78 (s, 3H), 4.42 (dd, 1H), 4.54 (dd, 1H), 5.78 (m, 2H), 6.11 (m, 1H), 6.29 (bt, 1H), 6.32 (s, 1H), 6.42 (m, 2H), 6.67 (d, 1H), 6.76 (d, 2H), 7.03 (m, 3H), 7.12 (t, 1H), 7.34 (d, 1H), 7.77 (m, 2H), 8.22 (d, 1H), 8.27 (d, 1H), 8.42 (d, 1H).

## Claims

1. An organic metal complex represented by the formula (I) 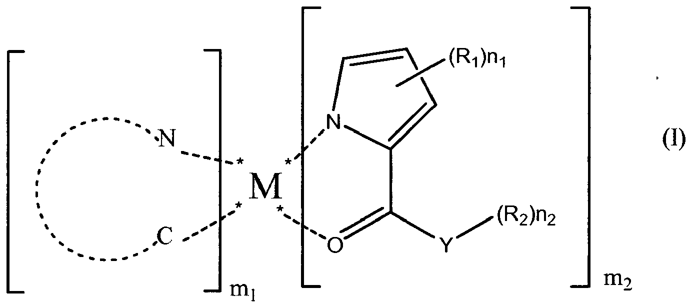 wherein
M is a metal selected from Rh, Ir, or Pt;
Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₃-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2;
m₁ has a value of at least 1; and
m₂ has a value of at least 1 provided that m₁+m₂ is 3;
wherein the ligand 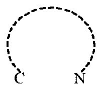 is independently at each occurrence a cyclometallated ligand which may be the same or different.

2. The complex according to claim 1, wherein Y represents N.

3. The complex according to claim 1, wherein R₁ represents a C₃-C₂₀ aralkyl, a C₃-C₁₄ aryl, a C₁-C₂₀ alkyl, a C₁-C₂₀ haloalkyl, C₁-C₂₀ alkenyl, C₁-C₂₀ alkynyl, C₁-C₂₀ alkenyl, or a C₃-C₇ cycloalkyl.

4. The complex according to claim 1, wherein R₂ represents a C₃-C₂₀ aralkyl, a C₃-C₁₄ aryl, a C₁-C₂₀ alkyl, a C₁-C₂₀ haloalkyl, C₁-C₂₀ alkenyl, C₁-C₂₀ alkynyl, C₁-C₂₀ alkenyl, or a C₃-C₇ cycloalkyl.

5. The complex according to claim 1, wherein R₂ represents a C₇-C₁₀ aralkyl, or a C₁-C₆ alkyl.

6. The complex according to claim 1, wherein X is CH, R₁ represents H, R₂ represents benzyl, n₁ is 0 and n₂ is 1.

7. The complex according to claim 1, wherein X is CH, R₁ represents H, R₂ represents ethyl, n₁ is 0 and n₂ is 2.

8. The complex according to claim 1, wherein M is Ir.

9. The complex according to claim 1, wherein in the cyclometalated ligand 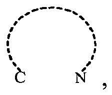 each of C and N is independently a ring-forming atom in an aromatic radical.

10. The complex according to claim 9, wherein in the cyclometalated ligand, C is a ring-forming atom in a C₃-C₁₄ aromatic radical; and N is a ring-forming atom in a nitrogen-containing C₃-C₁₄ aromatic radical.

11. A composition comprising at least one organic metal complex represented by the formula (I) 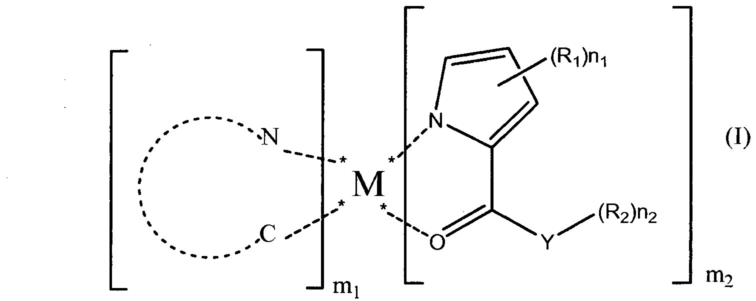 wherein
M is a metal selected from Rh, Ir, or Pt;
Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₃-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2;
m₁ has a value of at least 1; and
m₂ has a value of at least 1 provided that m₁+m₂ is 3;
wherein the ligand 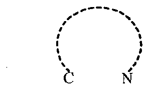 is independently at each occurrence a cyclometallated ligand which may be the same or different.

12. An electrophosphorescent composition comprising at least one electroactive host material and at least one organic metal complex represented by the formula (I) 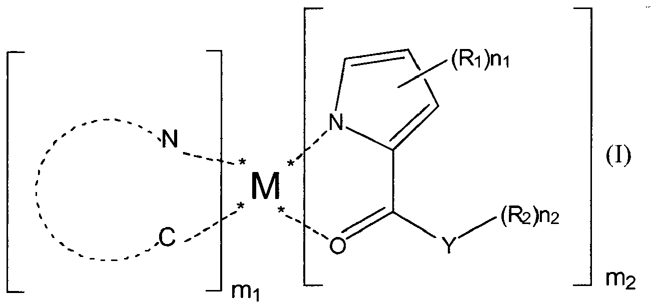 wherein
M is a metal selected from Rh, Ir, or Pt;
Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₃-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2;
m₁ has a value of at least 1; and
m₂ has a value of at least 1 provided that m₁+m₂ is 3;
wherein the ligand 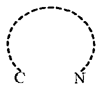 is independently at each occurrence a cyclometallated ligand which may be the same or different.

13. An organic light emitting device, comprising
an anode;
a cathode; and
an organic light emitting layer positioned between the anode and the cathode, wherein the organic light emission layer comprises an organic metal complex represented by the formula (I) 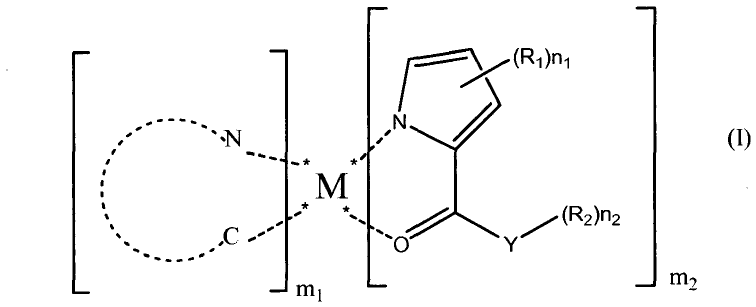 wherein
M is a metal selected from Rh, Ir, or Pt;
Y represents N or O;
R₁ represents a hydrogen, a halogen, a nitro group, an amino group, a hydroxyl group, a C₃-C₄₀ aromatic radical, a C₁-C₅₀ aliphatic radical, and a C₃-C₅₀ cycloaliphatic radical;
R₂ represents a hydrogen, C₃-C₂₀ aromatic radical, C₁-C₅₀ aliphatic radical, or a C₃-C₅₀ cycloaliphatic radical; or R₁ and R₂, together with the adjacent Y, may form a ring, preferably a 5- or 6-membered ring;
n₁ has a value of from 0 to 3; and
n₂ has a value of 0 to 2;
m₁ has a value of at least 1; and
m₂ has a value of at least 1 provided that m₁+m₂ is 3;
wherein the ligand 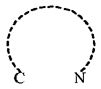 is independently at each occurrence a cyclometallated ligand which may be the same or different.

14. The organic light emitting device according to the claim 13, further comprising one or more layers selected from a hole injection layer; an electron injection layer; and an electron transport layer.

15. The organic light emitting device according to the claim 13, wherein the organic light emitting device is selected from the group consisting of light emitting electrochemical cells, photo detectors, photoconductive cells, photo switches, phototransistors, and phototubes.

## Patentansprüche

1. Organischer Metallkomplex, repräsentiert durch
die Formel (I) 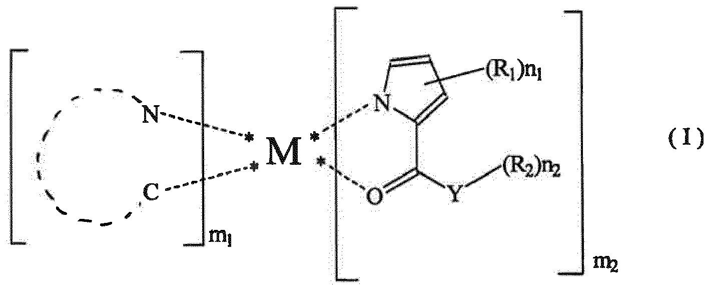 worin
M ein Metall ist, ausgewählt aus Rh, Ir oder Pt,
Y N oder O repräsentiert,
R₁ einen Wasserstoff, ein Halogen, eine Nitrogruppe, eine Aminogruppe, eine Hydroxylgruppe, einen aromatischen C₃-C₄₀-Rest, einen aliphatischen C₁-C₅₀-Rest und einen cycloaliphatischen C₃-C₅₀-Rest repräsentiert,
R₂ einen Wasserstoff, einen aromatischen C₃-C₂₀-Rest, einen aliphatischen C₁-C₅₀-Rest oder einen cycloaliphatischen C₃-C₅₀-Rest repräsentiert oder R₁ und R₂ zusammen mit dem benachbarten Y einen Ring, vorzugsweise einen 5- oder 6-gliederigen Ring, bilden können,
n₁ einen Wert von 0 bis 3 hat und
n₂ einen Wert von 0 bis 2 hat;
m₁ einen Wert von mindestens 1 hat und
m₂ einen Wert von mindestens 1 hat, unter der Bedingung, dass m₁ + m₂ 3 ist,
wobei der Ligand 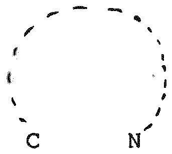 unabhängig bei jedem Vorkommen ein cyclometallisierter Ligand ist, der gleich oder verschieden sein kann.

2. Komplex nach Anspruch 1, worin Y N repräsentiert.

3. Komplex nach Anspruch 1, worin R₁ ein C₃-C₂₀-Aralkyl, ein C₃-C₁₄-Aryl, ein C₁-C₂₀-Alkyl, ein C₁-C₂₀-Halogenalkyl, C₁-C₂₀-Alkenyl, C₁-C₂₀-Alkinyl, C₁-C₂₀-Alkenyl oder ein C₃-C₇-Cycloalkyl repräsentiert.

4. Komplex nach Anspruch 1, worin R₂ ein C₃-C₂₀-Aralkyl, ein C₃-C₁₄-Aryl, ein C₁-C₂₀-Alkyl, ein C₁-C₂₀-Halogenalkyl, C₁-C₂₀-Alkenyl, C₁-C₂₀-Alkinyl, C₁-C₂₀-Alkenyl oder ein C₃-C₇-Cycloalkyl repräsentiert.

5. Komplex nach Anspruch 1, worin R₂ ein C₇-C₁₀-Aralkyl oder ein C₁-C₆-Alkyl repräsentiert.

6. Komplex nach Anspruch 1, worin X CH ist, R₁ H repräsentiert, R₂ Benzyl repräsentiert, n₁ 0 ist und n₂ 1 ist.

7. Komplex nach Anspruch 1, worin X CH ist, R₁ H repräsentiert, R₂ Ethyl repräsentiert, n₁ 0 ist und n₂ 2 ist.

8. Komplex nach Anspruch 1, worin M Ir ist.

9. Komplex nach Anspruch 1, worin in dem cyclometalli-sierten Liganden 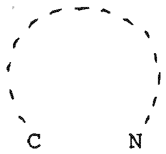 jedes von C und N unabhängig ein ringbildendes Atom in einem aromatischen Rest ist.

10. Komplex nach Anspruch 9, worin in dem cyclometallisierten Liganden C ein ringbildendes Atom in einem aromatischen C₃-C₁₄-Rest ist und N ein ringbildendes Atom in einem stickstoffhaltigen aromatischen C₃-C₁₄-Rest ist.

11. Zusammensetzung, umfassend mindestens einen organischen Metallkomplex, repräsentiert durch die Formel (I) 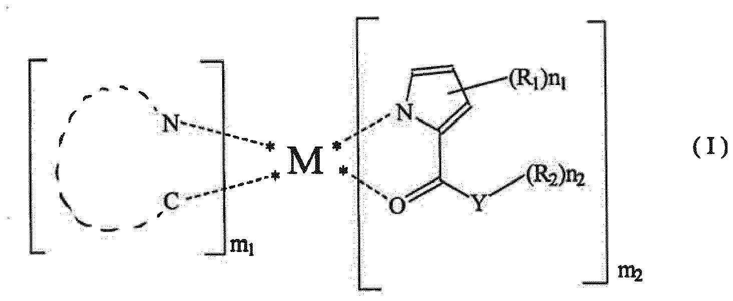 worin
M ein Metall ist, ausgewählt aus Rh, Ir oder Pt,
Y N oder O repräsentiert,
R₁ einen Wasserstoff, ein Halogen, eine Nitrogruppe, eine Aminogruppe, eine Hydroxylgruppe, einen aromatischen C₃-C₄₀-Rest, einen aliphatischen C₁-C₅₀-Rest und einen cycloaliphatischen C₃-C₅₀-Rest repräsentiert,
R₂ einen Wasserstoff, einen aromatischen C₃-C₂₀-Rest, einen aliphatischen C₁-C₅₀-Rest oder einen cycloaliphatischen C₃-C₅₀-Rest repräsentiert oder R₁ und R₂ zusammen mit dem benachbarten Y einen Ring, vorzugsweise einen 5- oder 6-gliederigen Ring, bilden können,
n₁ einen Wert von 0 bis 3 hat und
n₂ einen Wert von 0 bis 2 hat;
m₁ einen Wert von mindestens 1 hat und
m₂ einen Wert von mindestens 1 hat, unter der Bedingung, dass m₁ + m₂ 3 ist,
wobei der Ligand 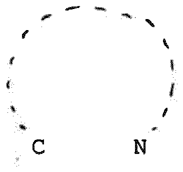 unabhängig bei jedem Vorkommen ein cyclometallisierter Ligand ist, der gleich oder verschieden sein kann.

12. Elektrophosphoreszierende Zusammensetzung, umfassend mindestens ein elektroaktives Wirtsmaterial und mindestens einen organischen Metallkomplex, repräsentiert durch die Formel (I) 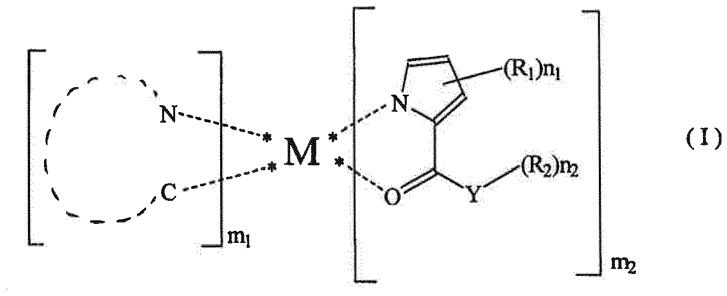 worin
M ein Metall ist, ausgewählt aus Rh, Ir oder Pt,
Y N oder O repräsentiert,
R₁ einen Wasserstoff, ein Halogen, eine Nitrogruppe, eine Aminogruppe, eine Hydroxylgruppe, einen aromatischen C₃-C₄₀-Rest, einen aliphatischen C₁-C₅₀-Rest und einen cycloaliphatischen C₃-C₅₀-Rest repräsentiert,
R₂ einen Wasserstoff, einen aromatischen C₃-C₂₀-Rest, einen aliphatischen C₁-C₅₀-Rest oder einen cycloaliphatischen C₃-C₅₀-Rest repräsentiert oder R₁ und R₂ zusammen mit dem benachbarten Y einen Ring, vorzugsweise einen 5- oder 6-gliederigen Ring, bilden können,
n₁ einen Wert von 0 bis 3 hat und
n₂ einen Wert von 0 bis 2 hat;
m₁ einen Wert von mindestens 1 hat und
m₂ einen Wert von mindestens 1 hat, unter der Bedingung, dass m₁ + m₂ 3 ist,
wobei der Ligand 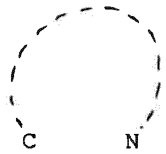 unabhängig bei jedem Vorkommen ein cyclometallisierter Ligand ist, der gleich oder verschieden sein kann.

13. Organische, Licht emittierende Vorrichtung, umfassend
eine Anode,
eine Kathode und
eine organische, Licht emittierende Schicht, die zwischen der Anode und der Kathode angeordnet ist, wobei die organische Lichtemissionsschicht einen organischen Metallkomplex umfasst, repräsentiert durch die Formel (I) 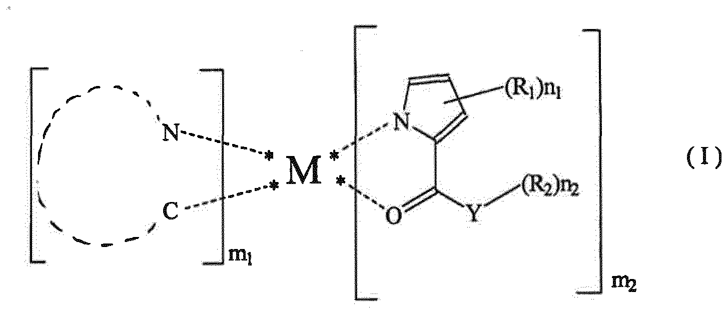 worin
M ein Metall ist, ausgewählt aus Rh, Ir oder Pt,
Y N oder O repräsentiert,
R₁ einen Wasserstoff, ein Halogen, eine Nitrogruppe, eine Aminogruppe eine Hydroxylgruppe, einen aromatischen C₃-C₄₀-Rest, einen aliphatischen C₁-C₅₀-Rest und einen cycloaliphatischen C₃-C₅₀-Rest repräsentiert,
R₂ einen Wasserstoff, einen aromatischen C₃-C₂₀-Rest, einen aliphatischen C₁-C₅₀-Rest oder einen cycloaliphatischen C₃-C₅₀-Rest repräsentiert oder R₁ und R₂ zusammen mit dem benachbarten Y einen Ring, vorzugsweise einen 5- oder 6-gliederigen Ring, bilden können,
n₁ einen Wert von 0 bis 3 hat und
n₂ einen Wert von 0 bis 2 hat;
m₁ einen Wert von mindestens 1 hat und
m₂ einen Wert von mindestens 1 hat unter der Bedingung, dass m₁ + m₂ 3 ist,
worin der Ligand 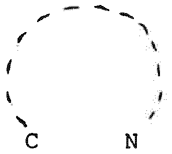 unabhängig bei jedem Vorkommen ein cyclometallisierter Ligand ist, der gleich oder verschieden sein kann.

14. Organische, Licht emittierende Vorrichtung nach Anspruch 13, weiter umfassend eine oder mehrere Schichten, ausgewählt aus einer Lochinjektionsschicht, einer Elektroneninjektionsschicht und einer Elektronentransportschicht.

15. Organische, Licht emittierende Vorrichtung nach Anspruch 13, worin die organische, Licht emittierende Vorrichtung ausgewählt ist aus der Gruppe bestehend aus Licht emittierenden elektrochemischen Zellen, Fotodetektoren, fotoleitenden Zellen, Fotoschaltern, Fototransistoren und Fotoröhren.

## Revendications

1. Complexe organo-métallique représenté par la formule (I) : 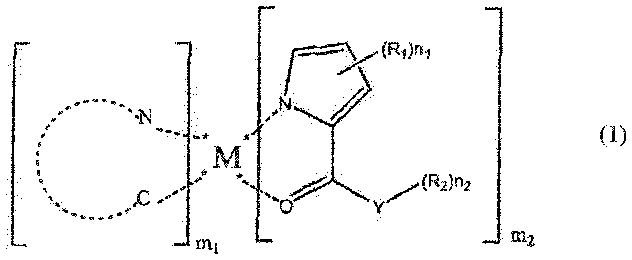 dans laquelle
- M représente un atome d'un métal choisi parmi le rhodium, l'iridium et le platine,
- Y représente un atome d'azote ou d'oxygène,
- R₁ représente un atome d'hydrogène ou d'halogène, un groupe nitro, amino ou hydroxyle, ou un reste aromatique en C₃-C₄₀, aliphatique en C₁-C₅₀ ou cycloaliphatique en C₃-C₅₀,
- et R₂ représente un atome d'hydrogène, ou un reste aromatique en C₃-C₂₀, aliphatique en C₁-C₅₀ ou cycloaliphatique en C₃-C₅₀,
- ou bien R₁ et R₂ peuvent représenter des entités qui, conjointement avec l'atome adjacent symbolisé par Y, forment un cycle, qui est de préférence un cycle à 5 ou 6 chaînons,
- l'indice n₁ vaut de 0 à 3,
- l'indice n₂ vaut de 0 à 2,
- l'indice m₁ vaut au moins 1,
- et l'indice m₂ vaut au moins 1,
- sous réserve que la somme (m₁ + m₂) vaille 3,
- et le ligand représenté par est un ligand de cyclométallation qui peut être, indépendamment en chaque occurrence, le même ligand ou un ligand différent.

2. Complexe conforme à la revendication 1, dans lequel Y représente un atome d'azote.

3. Complexe conforme à la revendication 1, dans lequel R₁ représente un groupe aralkyle en C₃-C₂₀, aryle en C₃-C₁₄, alkyle en C₁-C₂₀, halogénoalkyle en C₁-C₂₀, alcényle en C₁-C₂₀, alcynyle en C₁-C₂₀, ou cycloalkyle en C₃-C₇.

4. Complexe conforme à la revendication 1, dans lequel R₂ représente un groupe aralkyle en C₃-C₂₀, aryle en C₃-C₁₄, alkyle en C₁-C₂₀, halogénoalkyle en C₁-C₂₀, alcényle en C₁-C₂₀, alcynyle en C₁-C₂₀, ou cycloalkyle en C₃-C₇.

5. Complexe conforme à la revendication 1, dans lequel R₂ représente un groupe aralkyle en C₇-C₁₀ ou alkyle en C₁-C₆.

6. Complexe conforme à la revendication 1, dans lequel R₁ représente un atome d'hydrogène, R₂ représente un groupe benzyle, l'indice n₁ vaut 0 et l'indice n₂ vaut 1.

7. Complexe conforme à la revendication 1, dans lequel R₁ représente un atome d'hydrogène, R₂ représente un groupe éthyle, l'indice n₁ vaut 0 et l'indice n₂ vaut 2.

8. Complexe conforme à la revendication 1, dans lequel M représente un atome d'iridium.

9. Complexe conforme à la revendication 1, dans lequel chacun des atomes C et N du ligand de cyclométallation 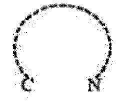 est indépendamment un atome chaînon de cycle dans un reste aromatique.

10. Complexe conforme à la revendication 9, dans lequel l'atome C du ligand de cyclométallation est un atome chaînon de cycle dans un reste aromatique en C₃-C₁₄, et l'atome N du ligand de cyclométallation est un atome chaînon de cycle dans un reste aromatique azoté en C₃-C₁₄.

11. Composition comprenant au moins un complexe organo-métallique représenté par la formule (I) : 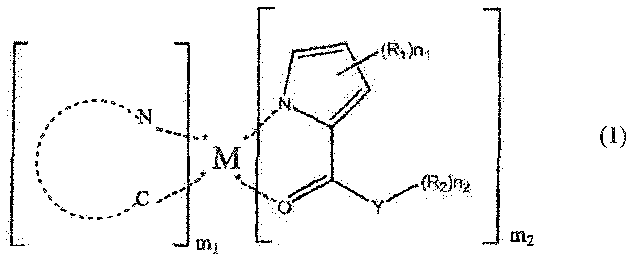 dans laquelle
- M représente un atome d'un métal choisi parmi le rhodium, l'iridium et le platine,
- Y représente un atome d'azote ou d'oxygène,
- R₁ représente un atome d'hydrogène ou d'halogène, un groupe nitro, amino ou hydroxyle, ou un reste aromatique en C₃-C₄₀, aliphatique en C₁-C₅₀ ou cycloaliphatique en C₃-C₅₀,
- et R₂ représente un atome d'hydrogène, ou un reste aromatique en C₃-C₂₀, aliphatique en C₁-C₅₀ ou cycloaliphatique en C₃-C₅₀,
- ou bien R₁ et R₂ peuvent représenter des entités qui, conjointement avec l'atome adjacent symbolisé par Y, forment un cycle, qui est de préférence un cycle à 5 ou 6 chaînons,
- l'indice n₁ vaut de 0 à 3,
- l'indice n₂ vaut de 0 à 2,
- l'indice m₁ vaut au moins 1,
- et l'indice m₂ vaut au moins 1,
- sous réserve que la somme (m₁ + m₂) vaille 3,
- et le ligand représenté par 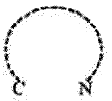 est un ligand de cyclométallation qui peut être, indépendamment en chaque occurrence, le même ligand ou un ligand différent.

12. Composition électrophosphorescente comprenant au moins un matériau hôte électro-attracteur et au moins un complexe organo-métallique représenté par la formule (I) : 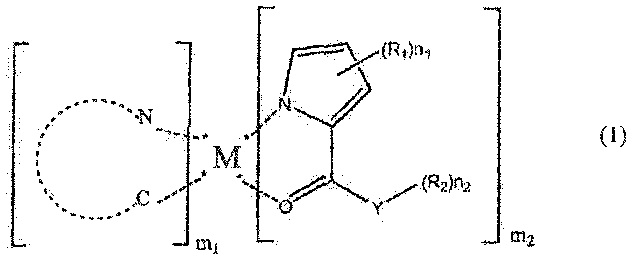 dans laquelle
- M représente un atome d'un métal choisi parmi le rhodium, l'iridium et le platine,
- Y représente un atome d'azote ou d'oxygène,
- R₁ représente un atome d'hydrogène ou d'halogène, un groupe nitro, amino ou hydroxyle, ou un reste aromatique en C₃-C₄₀, aliphatique en C₁-C₅₀ ou cycloaliphatique en C₃-C₅₀,
- et R₂ représente un atome d'hydrogène, ou un reste aromatique en C₃-C₂₀, aliphatique en C₁-C₅₀ ou cycloaliphatique en C₃-C₅₀,
- ou bien R₁ et R₂ peuvent représenter des entités qui, conjointement avec l'atome adjacent symbolisé par Y, forment un cycle, qui est de préférence un cycle à 5 ou 6 chaînons,
- l'indice n₁ vaut de 0 à 3,
- l'indice n₂ vaut de 0 à 2,
- l'indice m₁ vaut au moins 1,
- et l'indice m₂ vaut au moins 1,
- sous réserve que la somme (m₁ + m₂) vaille 3,
- et le ligand représenté par 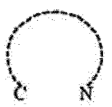 est un ligand de cyclométallation qui peut être, indépendamment en chaque occurrence, le même ligand ou un ligand différent.

13. Dispositif photoémetteur organique comprenant :
- une anode,
- une cathode,
- et une couche photoémettrice organique, placée entre l'anode et la cathode, laquelle couche photoémettrice organique comprend un complexe organo-métallique représenté par la formule (I) : 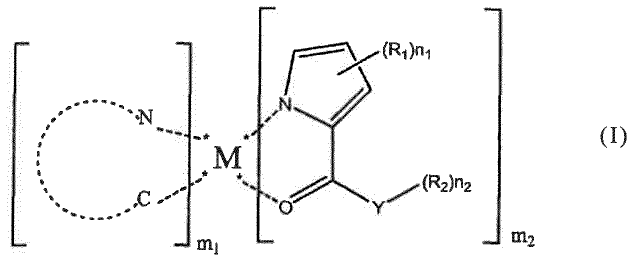 dans laquelle
- M représente un atome d'un métal choisi parmi le rhodium, l'iridium et le platine,
- Y représente un atome d'azote ou d'oxygène,
- R₁ représente un atome d'hydrogène ou d'halogène, un groupe nitro, amino ou hydroxyle, ou un reste aromatique en C₃-C₄₀, aliphatique en C₁-C₅₀ ou cycloaliphatique en C₃-C₅₀,
- et R₂ représente un atome d'hydrogène, ou un reste aromatique en C₃-C₂₀, aliphatique en C₁-C₅₀ ou cycloaliphatique en C₃-C₅₀,
- ou bien R₁ et R₂ peuvent représenter des entités qui, conjointement avec l'atome adjacent symbolisé par Y, forment un cycle, qui est de préférence un cycle à 5 ou 6 chaînons,
- l'indice n₁ vaut de 0 à 3,
- l'indice n₂ vaut de 0 à 2,
- l'indice m₁ vaut au moins 1,
- et l'indice m₂ vaut au moins 1,
- sous réserve que la somme (m₁ + m₂) vaille 3,
- et le ligand représenté par 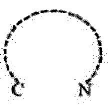 est un ligand de cyclométallation qui peut être, indépendamment en chaque occurrence, le même ligand ou un ligand différent.

14. Dispositif photoémetteur organique conforme à la revendication 13, qui comprend en outre une ou plusieurs couche(s) choisie(s) parmi une couche à injection de trous, une couche à injection d'électrons et une couche à transport d'électrons.

15. Dispositif photoémetteur organique conforme à la revendication 13, lequel dispositif photoémetteur organique est choisi dans l'ensemble constitué par les cellules électrochimiques photoémettrices, les photodétecteurs, les cellules photoconductrices, les photocommutateurs, les phototransistors et les phototubes.
